# EUROPEAN PATENT SPECIFICATION

(11) **EP 3 907 556 B1**
(45) Date of publication and mention of the grant of the patent: **03.04.2024**
(21) Application number: 19913930.4
(22) Date of filing: 01.02.2019
(51) Int. Cl.: G02F 1/1333, H04M 1/02, H10K 50/85

(54) **ELECTRONIC DEVICE AND DISPLAY APPARATUS**
ELEKTRONISCHE VORRICHTUNG UND ANZEIGEVORRICHTUNG
DISPOSITIF ÉLECTRONIQUE ET APPAREIL D'AFFICHAGE

(43) Date of publication of application: 10.11.2021
(73) Proprietor: GUANGDONG OPPO MOBILE TELECOMMUNICATIONS CORP., LTD., Dongguan, Guangdong 523860 (CN); Tsinghua University, Beijing 100084 (CN)
(72) Inventor: YUAN, Shilin, Dongguan, Guangdong 523860 (CN); CAO, Liangcai, Beijing 100084 (CN); WU, Jiachen, Beijing 100084 (CN); LI, Rujia, Beijing 100084 (CN)
(74) Representative: Thorniley, Peter
(86) International application number: PCT/CN2019/074511
(87) International publication number: WO 2020/155127

(56) References cited:
- EP-A1- 3 734 662
- CN-A- 104 362 169
- CN-A- 105 633 121
- CN-A- 106 200 148
- CN-A- 106 200 148
- CN-A- 108 232 031
- CN-A- 108 983 468
- US-A1- 2008 106 629
- US-A1- 2013 214 301

## Description

### BACKGROUND OF DISCLOSURE

### 1. Field of the Disclosure

The present disclosure relates to the field of electronic technology, and specifically to an electrical device and a display apparatus.

### 2. Description of the Related Art

With the development of communication technology, electronic devices such as smart phones are becoming more and more popular. During the use of the electronic device, the electronic device can use its display screen to display pictures. For example, EP 3734662 A1 discloses a display panel having film layers with a patterned structure; US 2013/214301 A1 discloses a display device including a plurality of light emitting devices corresponding to a plurality of first members, wherein a plurality of second members are formed in areas between adjacent the first members, and the first members and the second members are configured to reflect and guide at least a portion of light emitted from light emitting sections through the first members; US 2008/106629 A1 discloses an integrated imaging apparatus for displaying images while capturing images of a scene; CN 106200148 A discloses a display panel and a display apparatus with the display panel, wherein the display panel has a filling layer, in which a refractive index changes based on a voltage difference between a light control electrode and a common electrode.

In the related art, in order to obtain a larger screen-to-body ratio, the camera module of the electronic device is arranged under the display screen, and the camera module obtains optical signals passing through the display screen, thereby realizing under-screen imaging. However, due to a complex pixel structure in the display screen, the complex pixel structure will cause diffraction interference during imaging of the camera module, thereby reducing a quality of under-screen imaging.

### SUMMARY

The embodiments of the present disclosure provide an electronic device and a display apparatus, which can improve a quality of under-screen imaging.

An embodiment of the present disclosure provides an electronic device, which includes a display apparatus and a camera module, wherein the display apparatus includes:
a pixel definition layer defined with a plurality of pixel holes;
a plurality of organic light emitters, each of the organic light emitters disposed in one of the plurality of pixel holes;
a common electrode layer covering the organic light emitters and the pixel definition layer;
a filling layer comprising a plurality of filling members, each of the plurality of filling members disposed on one side of the common electrode layer away from the plurality of organic light emitters and opposite to one of the plurality of pixel holes;
wherein a difference between refractive indices of the pixel definition layer and each of the plurality of filling members is smaller than a difference between refractive indices of the pixel definition layer and vacuum; and
the camera module is at least partially disposed face to at least one of the plurality of pixel holes and configured to acquire an image through the display apparatus.

An embodiment of the present disclosure provides a display apparatus, which includes:
a pixel definition layer defined with a pixel hole;
an organic light emitter disposed in the pixel hole;
a common electrode layer covering the organic light emitter and the pixel definition layer;
a filling layer comprising a filling member disposed on one side of the common electrode layer away from the organic light emitter and opposite to the pixel hole;
wherein a difference between refractive indices of the pixel definition layer and the filling member is smaller than a difference between refractive indices of the pixel definition layer and vacuum.

### BRIEF DESCRIPTION OF DRAWINGS

In order to more clearly illustrate the technical solutions in the embodiments of the present disclosure, the following will briefly introduce the drawings that need to be used in the description of the embodiments. Obviously, the drawings in the following description are only some embodiments of the present disclosure. For those skilled in the art, other drawings can be obtained based on these drawings without creative work.
FIG. 1 is a schematic diagram of a first structure of an electronic device provided by an embodiment of the present disclosure.
FIG. 2 is a schematic diagram of a first structure of a display apparatus provided by an embodiment of the present disclosure.
FIG. 3 is a schematic diagram of a second structure of the display apparatus provided by an embodiment of the present disclosure.
FIG. 4 is a schematic diagram of a third structure of the display apparatus provided by an embodiment of the present disclosure.
FIG. 5 is a schematic diagram of a fourth structure of the display apparatus provided by an embodiment of the present disclosure.
FIG. 6 is a schematic diagram of a fifth structure of the display apparatus provided by an embodiment of the present disclosure.
FIG. 7 is a schematic diagram of a second structure of the electronic device provided by an embodiment of the application.
FIG. 8 is a schematic structural diagram of a pixel definition layer of the display apparatus provided by an embodiment of the present disclosure.
FIG. 9 is a schematic diagram of a third structure of the electronic device provided by an embodiment of the present disclosure.
FIG. 10 is a schematic diagram of a fourth structure of the electronic device provided by an embodiment of the present disclosure.

### DETAILED DESCRIPTION OF EMBODIMENTS

The technical solutions in the embodiments of the present disclosure will be clearly and completely described below in conjunction with the drawings in the embodiments of the present disclosure. Obviously, the described embodiments are only a part of the embodiments of the present disclosure, rather than all the embodiments. Based on the embodiments in the present disclosure, all other embodiments obtained by those skilled in the art without creative work shall fall within the protection scope of the present disclosure.

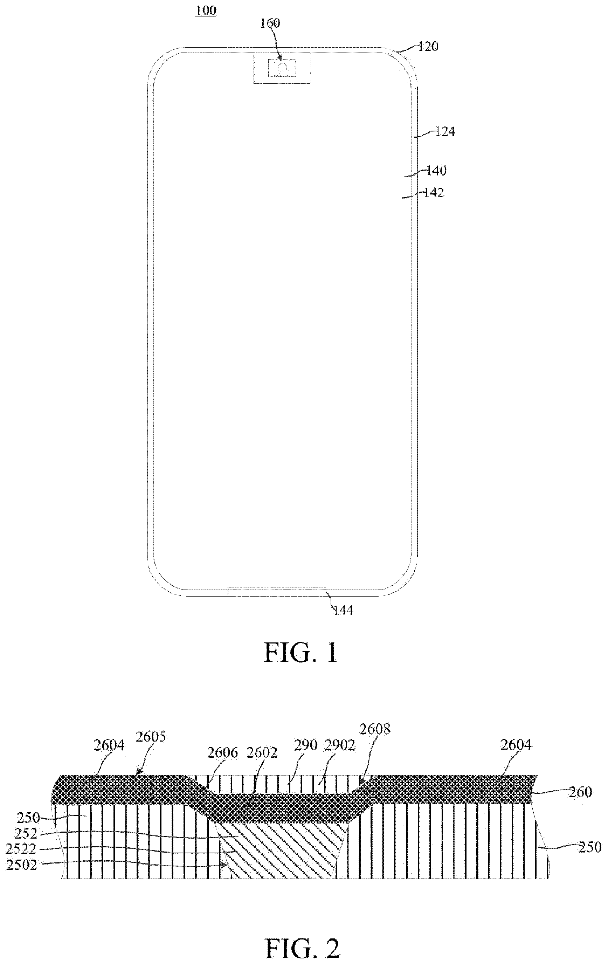

Please refer to FIG. 1, an electronic device 100 includes a housing 120, a display apparatus 140, and a camera module 160. The display apparatus 140 includes a display panel 142 and a driving circuit 144. The driving circuit 144 can drive the display panel 142 to display various images. The display apparatus 140 is disposed on the housing 120. The housing 120 may include a back cover and a frame 124. The frame 124 is arranged around a rim of the back cover. The display apparatus 140 is disposed in the frame 124. The display apparatus 140 and the back cover can be used as two sides opposite to each other of the electronic device. The camera module 160 is disposed between the back cover of the housing 120 and the display apparatus 140. It can also be understood that the camera module 160 includes an image-capturing surface for capturing images. The display apparatus 140 includes a display surface and a display back surface opposite to the display surface. The image-capturing surface of the camera module 160 is disposed toward a display back surface of the display apparatus 140. The camera module 160 acquires optical signals passing through the display apparatus 140 and obtains an image according to the acquired optical signals. In some embodiments, the camera module 160 can be used as a front camera of the electronic device 100. The camera module 160 can acquire an image, such as a user's selfie, through the display apparatus 140.

Please combine with FIG. 2, the display apparatus 140 of the electronic device 100 includes a pixel definition layer 250, a plurality of organic light emitters 2522, a common electrode layer 260, and a filling layer 290. The pixel definition layer 250 is defined with a plurality of pixel holes 2502. The organic light emitters 2522 are disposed in the plurality of pixel holes 2502. The common electrode layer 260 covers the plurality of organic light emitters 2522 and the pixel definition layer 250. The filling layer 290 includes a plurality of filling members 2902 which are disposed on one side of the common electrode layer 260 away from the plurality of organic light emitters 2522 and opposite to the plurality of pixel holes 2502.

A difference between refractive indices of the pixel definition layer 250 and the filling members 2902 is smaller than a difference between refractive indices of the pixel definition layer 250 and vacuum. The camera module 160 is at least partially disposed face to at least one of the plurality of pixel holes 2502 and acquires an image through the display apparatus 140.

It should be noted that when the optical signals pass through the display apparatus 140, a first optical path is defined by the optical signals passing through a first region corresponding to one of the plurality of pixel holes 2502, and a second optical path is defined by the optical signals passing through a second region not corresponding to one of the plurality of pixel holes 2502. There is an optical path difference between the first optical path and the second optical path. The common electrode layer 260 covers the plurality of organic light emitters 2522 and the pixel definition layer 250. The thicknesses of different parts of the common electrode layer 260 are approximately the same. The common electrode layer 260 has no or little effect on the optical path difference. Because optical parameters of the pixel definition layer 250 and the plurality of organic light emitters 2522 are different, the pixel definition layer 250 not corresponding to the pixel holes 2502 and each of the plurality of organic light emitters 2522 corresponding to a region of one of the plurality of pixel holes 2502 have a greater influence on the optical path difference. In addition, in the related art, due to the manufacturing process of the display apparatus, there is a gap in the display apparatus opposite to the region of each of the plurality of pixel holes. The gap is located on one side of the common electrode layer away from the pixel holes. Because there is no gap to the pixel definition layer, the gap also greatly influences the optical path difference. Because a difference between the light parameters of the vacuum and the pixel definition layer in the gap is huge, at this point, one embodiment of the present disclosure is provided with a plurality of filling members 2902, each of the plurality of filling members 2902 corresponding to the gap, and the difference between refractive indices of the pixel definition layer 250 and the plurality of filling members 2902 is smaller than the difference between refractive indices of the pixel definition layer 250 and the vacuum. The optical path difference between the first optical path and the second optical path can be improved, thereby improving an imaging quality of the camera module 160 through the display apparatus 140.

In some embodiments, the display apparatus 140 includes a pixel definition layer 250, an organic light-emitting layer 252, a common electrode layer 260, and a filling layer 290.

The pixel definition layer 250 is defined with a plurality of pixel holes 2502 arranged in an array manner. The organic light-emitting layer 252 includes a plurality of organic light emitters 2522 that are correspondingly disposed in the plurality of pixel holes 2502. The common electrode layer 260 covers the plurality of organic light emitters 2522 and the pixel definition layer 250. The filling layer 290 includes a plurality of filling members 2902 that are disposed on one side of the common electrode layer 260 away from the organic light emitters 2522. Also, each of the plurality of filling members 2902 is disposed opposite to one of the plurality of pixel holes 2502.

Each of the plurality of organic light emitters 2522 is disposed in one of the plurality of pixel holes 2502. Each of the plurality of pixel holes 2502 is provided with one of the plurality of organic light emitters 2522. Each of the plurality of pixel holes 2502 corresponds to one of the plurality of filling members 2902. The difference between the refractive indices of the pixel definition layer 250 and the plurality of filling members 2902 is smaller than the difference between the refractive indices of the pixel definition layer 250 and the vacuum. The camera module 160 is at least partially disposed face to at least one of the plurality of pixel holes 2502 and acquires an image through the display apparatus 140.

Similarly, the optical path difference between the first optical path and the second optical path can be improved by the filling layer 290, thereby improving the imaging quality of the camera module 160 through the display apparatus 140.

A thickness and a refractive index of the filling layer 290 can be derived from a thickness and a refractive index of the pixel definition layer 250 and a thickness and a refractive index of the organic light-emitting layer 252. The thickness and refractive index of the filling layer 290 can be obtained according to the optical path difference between the pixel definition layer 250 and the organic light-emitting layer 252, such that the optical path of the pixel definition layer 250 is approximately equal to a sum of optical paths of the organic light-emitting layer 252 and the filling layer 290.

The thickness and the refractive index of the pixel definition layer 250 are multiplied to obtain a third optical path, the thickness and the refractive index of the organic light-emitting layer 252 are multiplied to obtain a fourth optical path, and the thickness and the refractive index of the filling layer 290 are multiplied to obtain a fifth optical path. A sum of the fourth optical path and the fifth optical path is approximately equal to the third optical path. The fifth optical path can be determined according to the third optical path and the fourth optical path, and then the refractive index and the thickness of the filling layer 290 can be determined according to the fifth optical path.

The thickness of the filling layer 290 is less than or equal to a thickness difference between the pixel definition layer 250 and the organic light-emitting layer 252. The filling layer 290 is also a highly light-transmitting layer.

In some embodiments, a difference between the refractive indices of the filling layer 290 and the pixel definition layer 250 may be less than 0.3, also be less than 0.2 or also be less than 0.1. The optical path difference between the first optical path and the second optical path is improved.

In some embodiments, a refractive index of each of the plurality of organic light emitters 2522 is greater than a refractive index of the pixel definition layer 250, and a refractive index of the filling layer 290 is smaller than the refractive index of the pixel definition layer 250. The optical path difference between the first optical path and the second optical path is improved.

In some embodiments, referring to Table 1, the pixel definition layer 250 has different refractive indices for optical signals with different wavelengths. For example, the pixel definition layer 250 has a refractive index of 1.526 for blue optical signals (wavelength of 430 nm), a refractive index of 1.514 for green optical signals (wavelength of 530 nm), and a refractive index of 1.506 for red optical signals (wavelength of 630 nm). The selected filling layer 290 has a refractive index of 1.502 for blue optical signals, a refractive index of 1.494 for green optical signals, and a refractive index of 1.489 for red optical signals. It should be noted that the present embodiment is only an illustrative example. The thickness and refractive index of each of the plurality of filling members 2902 can be selected in the present disclosure according to the thickness and refractive index of the pixel definition layer 250 and the organic light-emitting layer 252, which are actually used.

**Table 1:**

| Film layers | Refractive index | | |
|---|---|---|---|
| | B (430nm) | G (530nm) | R (630nm) |
| Pixel definition layer | 1.526 | 1.514 | 1.506 |
| Filling layer | 1.502 | 1.494 | 1.489 |

In some embodiments, the common electrode layer 260 includes a plurality of first electrode parts 2602, a plurality of second electrode parts 2604, and a plurality of third electrode parts 2606. Each of the first electrode parts 2602 is disposed in one of the plurality of pixel holes 2502 and covers one of the plurality of organic light emitters 2522. Each of the plurality of second electrode parts 2604 covers the pixel definition layer 250. One of the first electrode parts 2602 and one of the second electrode parts 2604 are connected via one of the third electrode parts 2606. The first electrode parts 2602 and the third electrode parts 2606 form a plurality of first grooves 2608 together, and each of the filling members 2902 is disposed in one of the first grooves 2608.

Each of the plurality of organic light emitters 2522 is disposed in one of the plurality of pixel holes 2502, but the plurality of pixel holes 2502 do not be filled up with the plurality of organic light emitters 2522. Each of the first electrode parts 2602 of the common electrode layer 260 is disposed in one of the plurality of pixel holes 2502, and each of the plurality of second electrode parts 2604 of the common electrode layer 260 covers the pixel definition layer 250. There is a height difference between each of the first electrode parts 2602 and each of the second electrode parts 2604, such that one of the first electrode parts 2602 and one of the third electrode parts 2606 can form the first groove 2608 together, and each of the filling members 2902 is correspondingly disposed in one of the plurality of first grooves 2608.

In some embodiments, each of the second electrode parts 2604 includes a first surface 2605 away from the pixel definition layer 250. A surface of each of the plurality of filling members 2902 away from one of the plurality of organic light emitter 2522 is aligned with the first surface 2605.

The display apparatus 140 further includes a light-extracting material layer (capping layer, CPL) that covers the common electrode layer 260. The light-extracting material layer may be a flat layer.

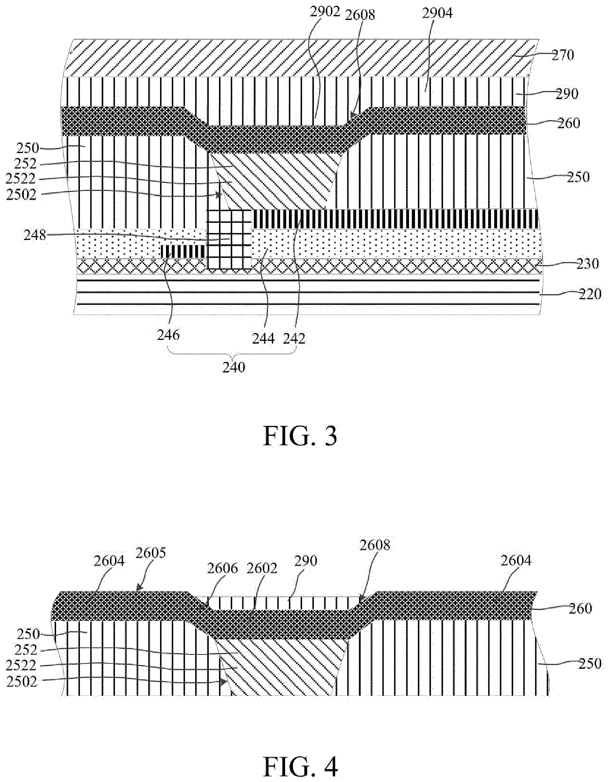

Please refer to FIG. 3, in some embodiments, the filling layer 290 further includes a connection member 2904 that covers the common electrode layer 260 and is connected to a plurality of filling members 2902.

Each of the plurality of filling members 2902 is filled in one of the plurality of first grooves 2608. The connection member 2904 can cover a whole layer. Namely, the connection member 2904 covers the common electrode layer 260 and the plurality of filling members 2902, as a whole. If each of the plurality of first grooves 2608 is just filled up with one of the plurality of filling members 2902, then two surfaces opposite to each other of the connection member 2904 are parallel.

Please refer to FIG. 4, in some embodiments, each of the plurality of second electrode parts 2604 includes a first surface 2605 away from the pixel definition layer 250, and a surface of each of the plurality of filling members 2902 away from one of the plurality of organic light emitters 2522 is lower or higher than the first surface 2605.

The surface of each of the plurality of filling members 2902 away from one of the plurality of organic light emitters 2522 may be lower or higher than the first surface 2605 of one of the plurality of first electrode parts 2602, to cooperate the optical parameters of the filling members 2902, thereby reducing the optical path difference between the first optical path and the second optical path.

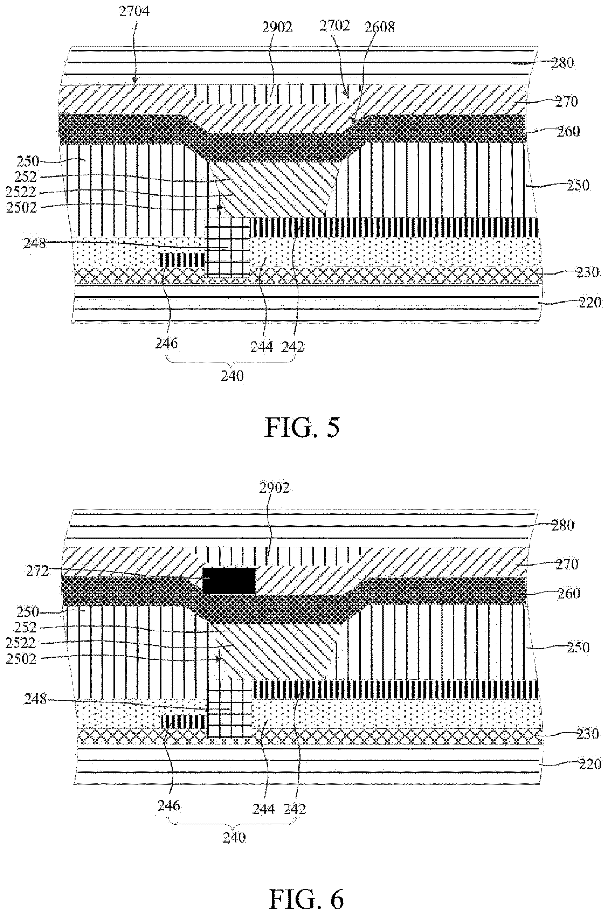

Please refer to FIG. 5, in some embodiments, the display apparatus 140 further includes a light-extracting material layer 270. The light-extracting material layer 270 covers the common electrode layer 260. The light-extracting material layer 270 is defined with a plurality of second grooves 2702 opposite to the plurality of pixel holes 2502. An opening of each of the plurality of second grooves 2702 away from one of the plurality of pixel holes 2502. Each of the filling member 2902 is disposed in one of the plurality of second grooves 2702.

Corresponding to the first grooves 2608 of the common electrode layer 260, the light-extracting material layer 270 is defined with the second grooves 2702. Each of the plurality of filling member 2902 is disposed in one of the plurality of second groove 2702, to make that impact on the original structure of the display apparatus 140 is smaller.

In some embodiments, the light-extracting material layer 270 includes a third surface 2704 away from the common electrode layer 260, and a surface of each of the plurality of filling members 2902 away from one of the organic light emitters 2522 is aligned with the third surface 2704.

The second groove 2702 may be filled up with the filling members 2902 to make that other structures covering the light-extracting material layer 270 are easier to implement and can smoothly cover.

In some embodiments, the light-extracting material layer includes a third surface away from the common electrode layer, and a surface of each of the plurality of filling members away from one of the plurality of organic light emitters is lower than the third surface.

Each of the filling members can be filled in one of the plurality of second grooves. The second grooves may not be filled up with the filling members according to their optical parameters, so other structures covering the light-extracting material layer do not be affected.

In some embodiments, the display apparatus 140 further includes a first substrate 220, an anode metal layer 240, and a second substrate 280, which are stacked.

The pixel definition layer 250 is disposed between the anode metal layer 240 and the common electrode layer 260. The common electrode layer 260 is disposed between the pixel definition layer 250 and the second substrate 280.

The anode metal layer 240 includes a first anode metal layer 242, a planarization layer 244, and a second anode metal layer 246, which are stacked. The first anode metal layer 242 is disposed between the first substrate 220 and the planarization layer 244. The second anode metal layer 246 is disposed between the planarization layer 244 and the pixel definition layer 250.

In some embodiments, the display apparatus 140 may include a first substrate 220, an anode metal layer 240, a pixel definition layer 250, a common electrode layer 260, a light-extracting material layer 270, and a second substrate 280, which are stacked.

In some embodiments, a first optical path in a direction perpendicular to the first substrate is defined at a position of the display apparatus 140 corresponding to a location of one of the plurality of pixel holes 2502, and a second optical path in the direction perpendicular to the first substrate is defined at a position of the display apparatus 140 corresponding to a location outside the plurality of pixel holes 2502, wherein the first optical path is equal to the second optical path.

The first optical path can be understood as an optical path of the optical signals passing through the display apparatus 140 from the position corresponding to the location of one of the plurality of pixel holes 2502 in the direction perpendicular to the first substrate 220. The first optical path can specifically be a sum of products of the thickness and the refractive index corresponding to each layer of the second substrate 280, the light-extracting material layer 270, the filling layer 290, the common electrode layer 260, the organic light-emitting layer 252, the anode metal layer 240, and the first substrate 220.

The second optical path can be understood as an optical path of the optical signals passing through the display apparatus 140 from the position not corresponding to the location of one of the plurality of pixel holes 2502 in the direction perpendicular to the first substrate 220. The first optical path can specifically be a sum of products of the thickness and the refractive index of each layer of the second substrate 280, the light-extracting material layer 270, the common electrode layer 260, the pixel definition layer 250, the anode metal layer 240, and the first substrate 220.

Because each layer of the second substrate 280, the light-extracting material layer 270, the common electrode layer 260, the anode metal layer 240, and the first substrate 220 covers another layer as a whole, and the thicknesses of different parts of each layer are approximately the same, the optical path difference between the first optical path and the second optical path corresponding to the second substrate 280, the light-extracting material layer 270, the common electrode layer 260, the anode metal layer 240, and the first substrate 220 can be ignored.

It should be noted that the first optical path equal to the second optical path can be understood to mean that the first optical path and the second optical path are approximately equal.

In some embodiments, an anode metal layer 240 and a common electrode layer 260 jointly drive an organic light-emitting layer 252 to display an image. The display apparatus 140 further includes a thin film transistor 248. The first anode metal layer 242, the second anode metal layer 246, and the organic light-emitting layer 252 are respectively connected to different electrodes of the thin film transistor 248. Also, the first anode metal layer 242 and the second anode metal layer 246 are controlled by the thin film transistor 248 to provide a positive signal to the organic light-emitting layer 252. After the positive signal is provided to the organic light-emitting layer 252, a negative electrode provided by the common electrode layer 260 is combined to control whether the organic light-emitting layer 252 emits light.

In some embodiments, a material of the first anode metal layer 242 is nano-silver.

The first anode metal layer 242 may be disposed between the organic light emitters 2522 and the planarization layer 244. The first anode metal layer 242 may include a plurality of first conductive wires and is made of nano-silver. Each of the first conductive wires made of nano-silver can be made thinner under the condition that impedance characteristic is satisfied. The thinner first metal layer has a smaller thickness and has a smaller influence on the first optical path. Because the plurality of first conductive wires of the first anode metal layer 242 do not cover another whole layer, the thickness of the first anode metal layer 242 is smaller, and the influence on the first optical path is also smaller. It should be noted that a material of the second anode metal layer 246 may be indium tin oxide (ITO) or nano-silver. It should be noted that the plurality of first conductive wires also extend to positions between the planarization layer 244 and the pixel definition layer 250, thereby reducing the influence on the second optical path.

In some embodiments, a material of the second anode metal layer 246 is nano-silver.

The first anode metal layer 242 may be disposed between the pixel definition layer 250 and the planarization layer 244. The second anode metal layer 246 may include a plurality of second conductive wires and is made of nano-silver. Each of the second conductive wires made of nano-silver can be made thinner under the condition that impedance characteristic is satisfied. The thinner second metal layer has a smaller thickness and has a smaller influence on the second optical path. Because the plurality of second conductive wires of the second anode metal layer 246 do not cover another whole layer, the thickness of the second anode metal layer 246 is smaller, and the influence on the second optical path is also smaller. It should be noted that the material of the first anode metal layer 242 can be indium tin oxide (ITO) or nano-silver.

In some embodiments, materials of the first anode metal layer 242 and the second anode metal layer 246 are nano-silver.

Both of the first anode metal layer 242 and the second anode metal layer 246 are made of nano-silver, and the thicknesses of the first anode metal layer 242 and the second anode metal layer 246 are smaller, and the influence on the first optical path and the second optical path is also smaller.

In some embodiments, a first compensation layer may be provided corresponding to the first anode metal layer 242, that is, the first compensation layer filled between a plurality of first conductive wires. The first compensation layer is made of insulation material with light transmission and has optical parameters similar to that of the first conductive wires, thereby the first optical path and the second optical path being not affected. The thicknesses of the first compensation layer and the plurality of first conductive wires are the same.

A second compensation layer can be provided corresponding to the second anode metal layer 246, that is, the second compensation layer filled between a plurality of second conductive wires. The second compensation layer is made of insulation material with light transmission and has optical parameters similar to that of the second conductive wires, thereby the first optical path and the second optical path being not affected. The thicknesses of the second compensation layer and the plurality of second conductive wires are the same.

In some embodiments, the display apparatus further includes a thin film 230 disposed between the first substrate 220 and the anode metal layer 240. The thin film 230 may be made of SiNx or SiO2.

Please refer to FIG. 6, in some embodiments, the display apparatus 140 further includes a plurality of light-shielding blocks 272 used to block light and a plurality of thin film transistors 248.

The thin film transistors 248 are disposed between the first substrate 220 and the organic light-emitting layer 252, the light-shielding blocks 272 are disposed between the common electrode layer 260 and the second substrate 280, and each of the light-shielding blocks 272 is at least partially disposed opposite to one of the thin film transistors 248.

Each of the plurality of light-shielding blocks 272 may be a black or dark-colored material, and each of the plurality of light-shielding blocks 272 may be used to block light entering the display apparatus 140. Each of the plurality of light-shielding blocks 272 is disposed corresponding to one of the plurality of thin film transistors 248. The light-shielding blocks 272 may be disposed between the organic light-emitting layer 252 and the second substrate 280. Each of the plurality of light shielding blocks 272 is at least partially disposed opposite to one of the plurality of thin film transistors 248. For example, a projection of each of the plurality of thin film transistors 248 on the first substrate 220 may be located within a projection of one of the plurality of light-shielding blocks 272 on the first substrate 220. In this way, it is possible to prevent light from being reflected and refracted by the thin film transistors 248 after entering the display apparatus 140, resulting in stray light interfering with imaging.

In some embodiments, the light-shielding blocks 272 may be disposed in the light-extracting material layer 270. For example, the light-extraction material layer 270 defines a plurality of through-holes or grooves, each at a position corresponding to one of the plurality of thin film transistors 248, and each of the plurality of light-shielding blocks 272 is correspondingly disposed in one of the plurality of through-holes or grooves, wherein an opening of each of the plurality of grooves may face the second substrate 280 or the common electrode layer 260.

In one implementation, a position of the second substrate 280 corresponding to each of the plurality of thin film transistors 248 may define one of the plurality of grooves, and each of the plurality of light-shielding blocks 272 is correspondingly disposed in one of the plurality of grooves of the second substrate 280, wherein the opening of each of the plurality of grooves of the second substrate 280 faces the common electrode layer 260. In one implementation, each of the plurality of light-shielding blocks 272 may also be disposed in a gap between the organic light-emitting layer 252 and the common electrode layer 260.

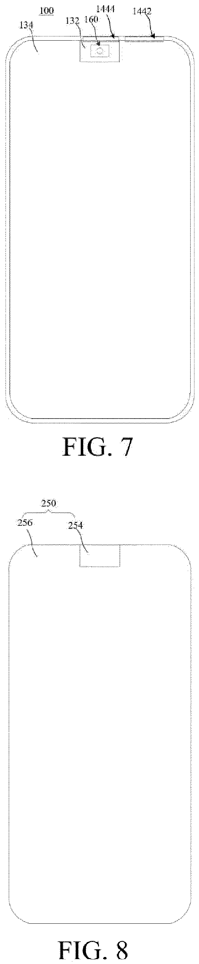

Please refer to FIG. 7, in some embodiments, the display apparatus 140 includes a light-transmitting region 132 and a main-body region 134, an area of the light-transmitting region 132 is smaller than an area of the main-body region 134, light transmittance of the light-transmitting region 132 is greater than light transmittance of the main-body region 134, and the camera module 160 is at least partially face to the light-transmitting region 132.

The light-transmitting region 132 is connected to a first driving module 1444, the main-body region 134 is connected to a second driving module 1442, the first driving module 1444 drives the light-transmitting region 132 of the display apparatus 140, and the second driving module 1442 drives the main-body region 134 of the display apparatus 140. The first driving module 1442 and the second driving module 1444 can cooperatively drive, such that the light-transmitting region 132 and the main-body region 134 display the same image together. For example, the light-transmitting region 132 displays a part of the image, and the main-body region 134 displays the remaining part of the image. When the camera module 160 needs to acquire an image, the first driving module 1444 drives the light-transmitting region 132 to turn off a display function, and the second driving module 1442 can continue to drive the main-body region 134 to display images, and the camera module 160 acquires external optical signals through the light-transmitting region 132 which is turned off the display function, and the image is obtained according to the optical signals.

In some embodiments, a distribution density of pixel holes within the light-transmitting region 132 is less than a distribution density of pixel holes within the main-body region 134.

Please refer to FIG. 8, specifically, in some embodiments, the pixel definition layer 250 includes a first part 254 and a second part 256. The first part 254 corresponds to the light-transmitting region. The second part 256 corresponds to the main-body region. An area of the first part 254 is smaller than an area of the second part 256. Light transmittance of the first part 254 is greater than light transmittance of the second electrode part 2604. The camera module 160 can acquire the optical signals through the first part 254 of the display apparatus 140 to form an image according to the optical signals.

Correspondingly, the camera module is disposed corresponding to the first part 254, and the camera module can acquire optical signals through a region corresponding to the first part 254 of the display apparatus 140, and light transmittance of the display apparatus corresponding to the first part 254 is greater than light transmittance of the display apparatus corresponding to the second part 256. Specifically, a distribution density of organic light emitters corresponding to the first part 254 is smaller, that is, smaller than a distribution density of organic light emitters corresponding to the second part 256. The distribution density of organic light emitters corresponding to the first part 254 is smaller, and the distribution density of thin film transistors that are opaque and corresponding to the organic light emitters in a manner of one-by-one correspondence is also smaller, thereby improving the light transmittance of the display apparatus corresponding to the first part 254.

In some embodiments, a distribution density of organic light emitters within the first part 254 is less than a distribution density of organic light emitters within the second part 256. It can also be understood that a distance between adjacent two of pixel holes within the first part 254 is greater than a distance between adjacent two of pixel holes within the second part 256. Light transmittance of the pixel definition layer 250 is greater than light transmittance of each of the organic light emitters. A proportion of the organic light-emitting layer of the first part 254 is smaller, such that the light transmittance of the first part 254 is greater than the light transmittance of the second part 256. In addition, each of the organic light emitters is provided with one of the thin film transistors that are opaque. The distribution density of organic light emitters within the first part 254 is smaller, and the distribution density of corresponding thin film transistors is also smaller, such that the light transmittance of the first part 254 is greater than the light transmittance of the second part 256.

In some embodiments, the first part 254 is located at an end of the pixel definition layer 250. Specifically, the first part 254 may be located at a top end or bottom end or on one side, of the pixel definition layer 250. For example, the pixel definition layer 250 is shaped like a rectangle, the second part 256 is shaped like a rectangle with a notch, and the first part 254 is disposed within the notch. The notch may be defined on a top edge or a bottom edge, or one side edge of the second part 256. Certainly, the first part 254 can also be disposed in a middle portion of the pixel definition layer 250. Also, it can be understood that the second part 256 is defined with a through-hole penetrating the second part 256 in a direction of thickness. The first part 254 is disposed in the through-hole.

The light-transmitting region and the main-body region are mainly different in the pixel definition layer 250 and the organic display layer. The light-transmitting region and the main-body region may share the same one first substrate 220, second substrate 280, and so on. The filling layer 290 may only be provided within the light-transmitting region or may be provided within the light-transmitting region and the main-body region.

It should be noted that, in conjunction with FIG. 5, the anode metal layer 240 corresponding to the first part 254 can be made of a material with high light transmissions, such as ITO, nano-silver, and the like. The anode metal layer 240 corresponding to the second part 256 may be made of a material with high light transmissions or may be made of a material with low light transmission or opacity.

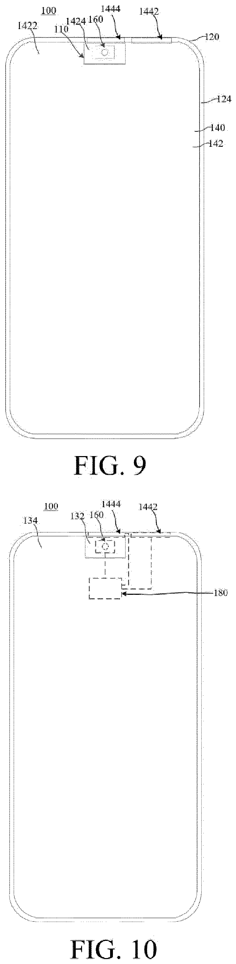

Please refer to FIG. 9, in some embodiments, the display apparatus 140 may include a first display panel 1422 and a second display panel 1424. The first display panel 1422 defines a notch 110 penetrating the first display panel 1422 in a direction of thickness of the first display panel 1422. The first display panel 1422 is the display panel 142 that is normally displayed. The second display panel 1424 is disposed in the notch 110. The second display panel 1424 corresponds to the light-transmitting region of the display apparatus 140. The first display panel 1422 corresponds to the main-body region of the display apparatus 140. The camera module 160 of the electronic device 100 is disposed between the housing and the second display panel 1424. The camera module 160 acquires the optical signals passing through the light-transmitting region to obtains an image according to the acquired optical signals.

The first display panel 1422 and the second display panel 1424 are two independent display panels. The first display panel 1422 and the second display panel 1424 are manufactured, respectively. The second display panel 1424 is then placed in the notch 100 of the first display panel 1422.

It should be noted that the first display panel 1422 is connected to the second drive module 1442, the second display panel 1424 is connected to the first drive module 1444, the first drive module 1444 drives the second display panel 1424, the second drive module 1442 drives the first display panel 1442, and the first driving module 1442 and the second driving module 1444 cooperatively drive, such that the first display panel 1422 and the second display panel 1424 display the same image together. For example, the first display panel 1422 displays a part of the image, and the second display panel 1424 displays the remaining part of the image. When the camera module 160 needs to acquire an image, the first drive module 1444 drives the second display panel 1424 to turn off a display function, the second drive module 1442 can continue to drive the first display panel 1422 to display images, and the camera module 160 acquires external optical signals through the second display panel 1424 that is turned off the display function, to acquire the image according to the optical signals.

In some embodiments, an acquisition surface of the camera module 160 for acquiring images may be made very small, an area of a single organic light emitter of the display apparatus 140 is larger, and the acquisition surface of the camera module 160 is equal to or smaller than an area of the single organic light emitter. The camera module 160 can acquires images through the organic light emitter.

In some embodiments, an acquisition surface of the camera module 160 for acquiring images may be made very small, a spacing between adjacent two of the organic light emitters in the display apparatus 140 is relatively large, and the acquisition surface of the camera module 160 is equal to or less than the spacing. The camera module 160 can acquire images through the spacing between two organic light emitters.

Please refer to FIG. 10. In some embodiments, the electronic device further includes a processor 180. The display apparatus 140 and the camera module 160 are electrically connected to the processor 180.

When an image-acquiring command is received, the processor 180 controls the light-transmitting region 132 to turn off a display function and controls the camera module 160 to acquire an image through the light-transmitting region 132. When no image-acquiring command is received and an image-displaying command is received, the processor 180 controls the light-transmitting region 132 and the main-body region 134 to display images together.

Please continue to refer to FIG. 2, the display apparatus of an embodiment of the present disclosure includes a pixel definition layer 250, an organic light emitter 2522, a common electrode layer 260, and a filling layer 290. The pixel definition layer 250 is defined with a pixel hole 2502. The organic light emitter 2522 is disposed in the pixel hole 2502. The common electrode layer 260 covers the organic light emitter 2522 and the pixel definition layer 250. The filling layer 290 includes a filling member 2902 which is disposed on one side of the common electrode layer 260 away from the organic light emitter 2522 and opposite to the pixel hole 2502.

A difference between refractive indices of the pixel definition layer 250 and the filling member 2902 is smaller than a difference between refractive indices of the pixel definition layer 250 and vacuum.

It should be noted that when the optical signals pass through the display apparatus 140, a first optical path is defined by the optical signals passing through a first region corresponding to the pixel hole 2502, and a second optical path is defined by the optical signals passing through a second region not corresponding to the pixel hole 2502. There is an optical path difference between the first optical path and the second optical path. The common electrode layer 260 covers the organic light emitter 2522 and the pixel definition layer 250. The thicknesses of different parts of the common electrode layer 260 are approximately the same. The common electrode layer 260 has no or little effect on the optical path difference. Because optical parameters of the pixel definition layer 250 and the organic light emitter 2522 are different, the pixel definition layer 250 not corresponding to the pixel hole 2502 and the organic light emitter 2522 corresponding to a region of the pixel hole 2502 have a greater influence on the optical path difference. In addition, in the related art, due to the manufacturing process of the display apparatus 140, there is a gap in the display apparatus opposite to the region of the pixel hole 2502. The gap is located on one side of the common electrode layer 260 away from the pixel hole 2502. Because there is no gap to the pixel definition layer 250, the gap also greatly influences the optical path difference. Because a difference between the light parameters of the vacuum and the pixel definition layer 250 in the gap is huge, at this point, one embodiment of the present disclosure is provided with a filling member 2902 corresponding to the gap, and the difference between refractive indices of the pixel definition layer 250 and the filling member 2902 is smaller than the difference between refractive indices of the pixel definition layer 250 and the vacuum. The optical path difference between the first optical path and the second optical path can be improved, thereby improving differences of optical signals passing through different positions of the display apparatus.

In some embodiments, the display apparatus includes a pixel definition layer 250, an organic light-emitting layer 252, a common electrode layer 260, and a filling layer 290.

The pixel definition layer 250 is defined with a plurality of pixel hole 2502 arranged in an array manner. The organic light-emitting layer 252 includes a plurality of organic light emitters 2522 that are correspondingly disposed in the plurality of pixel holes 2502. The common electrode layer 260 covers the organic light emitters 2522 and the pixel definition layer 250. The filling layer 290 includes a plurality of filling members 2902 that are disposed on one side of the common electrode layer 260 away from the organic light emitters 2522. Also, each of the filling members 2902 is disposed opposite to one of the pixel holes 2502.

Each of the organic light emitters 2522 is disposed in one of the pixel holes 2502. Each of the pixel holes 2502 is provided with one of the organic light emitters 2522. Each of the pixel holes 2502 corresponds to one of the filling members 2902. The difference between the refractive indices of the pixel definition layer 250 and the filling members 2902 is smaller than the difference between the refractive indices of the pixel definition layer 250 and the vacuum. The optical path difference between the first optical path and the second optical path can be improved by the filling layer 290, thereby improving differences of optical signals passing through different positions of the display apparatus.

A thickness and a refractive index of the filling layer 290 can be derived from a thickness and a refractive index of the pixel definition layer 250 and a thickness and a refractive index of the organic light-emitting layer 252. The thickness and the refractive index of the filling layer 290 can be obtained according to the optical path difference between the pixel definition layer 250 and the organic light-emitting layer 252, such that the optical path of the pixel definition layer 250 is approximately equal to a sum of optical paths of the organic light-emitting layer 252 and the filling layer 290.

The thickness and the refractive index of the pixel definition layer 250 are multiplied to obtain a third optical path, the thickness and the refractive index of the organic light-emitting layer 252 are multiplied to obtain a fourth optical path, and the thickness and the refractive index of the filling layer 290 are multiplied to obtain a fifth optical path. A sum of the fourth optical path and the fifth optical path is approximately equal to the third optical path. The fifth optical path can be determined according to the third optical path and the fourth optical path, and then the refractive index and the thickness of the filling layer 290 can be determined according to the fifth optical path.

The thickness of the filling layer 290 is less than or equal to a thickness difference between the pixel definition layer 250 and the organic light-emitting layer 252. The filling layer 290 is also a highly light-transmitting layer.

In some embodiments, a difference between the refractive indices of the filling layer 290 and the pixel definition layer 250 may be less than 0.3, also be less than 0.2 or also be less than 0.1. The optical path difference between the first optical path and the second optical path is improved.

In some embodiments, a refractive index of the organic light emitter 2522 is greater than a refractive index of the pixel definition layer 250, and a refractive index of the filling layer 290 is smaller than the refractive index of the pixel definition layer 250. The optical path difference between the first optical path and the second optical path is improved.

In some embodiments, the common electrode layer 260 includes a first electrode part 2602, a second electrode part 2604, and a third electrode part 2606. The first electrode part 2602 is disposed in a pixel hole 2502 and covers the organic light emitter 2522. The second electrode part 2604 covers the pixel definition layer 250. The first electrode part 2602 and the second electrode part 2604 are connected via the third electrode part 2606. The first electrode part 2602 and the third electrode part 2606 form a first groove 2608 together, and the filling member 2902 is disposed in the first groove 2608.

The organic light emitter 2522 is disposed in the pixel hole 2502, but the pixel hole 2502 does not be filled up with the organic light emitter 2522. The first electrode part 2602 of the common electrode layer 260 is disposed in the pixel hole 2502, the second electrode part 2604 of the common electrode covers the pixel definition layer 250. There is a height difference between the first electrode part 2602 and the second electrode part 2604, such that the first electrode part 2602 and the third electrode part 2606 can form the first groove 2608 together, and the filling member 2902 is correspondingly disposed in the first groove 2608.

In some embodiments, the second electrode part 2604 includes a first surface 2605 away from the pixel definition layer 250. A surface of the filling member 2902 away from the organic light emitter 2522 is aligned with the first surface 2605.

The display apparatus 140 further includes a light-extracting material layer that covers the common electrode layer 260. The light-extracting material layer may be a flat layer.

Please continue to refer to FIG. 3, in some embodiments, the filling layer 290 further includes a connection member 2904 that covers the common electrode layer 260 and is connected to a plurality of filling members 2902.

The filling member 2902 is filled in the first groove 2608. The connection member 2904 can cover a whole layer. Namely, the connection member 2904 covers the common electrode layer 260 and the filling member 2902, as a whole. If the first groove 2608 is just filled up with the filling member 2902, then two surfaces opposite to each other of the connection member 2904 are parallel.

Please continue to refer to FIG. 4, in some embodiments, the second electrode part 2604 includes a first surface 2605 away from the pixel definition layer 250, and a surface of the filling member 2902 away from the organic light emitter 2522 is lower or higher than the first surface 2605.

The surface of the filling member 2902 away from the organic light emitter 2522 may be lower or higher than the first surface 2605 of the first electrode part 2602, to cooperate the optical parameters of the filling member 2902, thereby reducing the optical path difference between the first optical path and the second optical path.

Please continue to refer to FIG. 5, in some embodiments, the display apparatus 140 further includes a light-extracting material layer 270. The light-extracting material layer 270 covers the common electrode layer 260. The light-extracting material layer 270 has a second groove 2702 opposite to the pixel hole 2502. An opening of the second groove 2702 away from the pixel hole 2502. The filling member 2902 is disposed in the second groove 2702.

Corresponding to the first groove 2608 of the common electrode layer 260, the light-extracting material layer 270 has the second groove 2702. The filling member 2902 is disposed in the second groove 2702, to make that impact on the original structure of the display apparatus 140 is smaller.

In some embodiments, the light-extracting material layer 270 includes a third surface 2704 away from the common electrode layer 260, and a surface of the filling member 2902 away from the organic light emitter 2522 is aligned with the third surface 2704.

The second groove 2702 may be filled up with the filling member 2902 to make that other structures covering the light-extracting material layer 270 are easier to implement and can smoothly cover.

In some embodiments, the light-extracting material layer includes a third surface away from the common electrode layer, and a surface of the filling member away from the organic light emitter is lower than the third surface.

The filling member can be filled in the second groove. The second groove may not be filled up with the filling member according to its optical parameters, so other structures covering the light-extracting material layer do not be affected.

In some embodiments, the display apparatus 140 further includes a first substrate 220, an anode metal layer 240, and a second substrate 280, which are stacked.

The pixel definition layer 250 is disposed between the anode metal layer 240 and the common electrode layer 260. The common electrode layer 260 is disposed between the pixel definition layer 250 and the second substrate 280.

The anode metal layer 240 includes a first anode metal layer 242, a planarization layer 244, and a second anode metal layer 246, which are stacked. The first anode metal layer 242 is disposed between the first substrate 220 and the planarization layer 244. The second anode metal layer 246 is disposed between the planarization layer 244 and the pixel definition layer 250.

In some embodiments, the display apparatus 140 may include a first substrate 220, an anode metal layer 240, a pixel definition layer 250, a common electrode layer 260, a light-extracting material layer 270, and a second substrate 280, which are stacked.

In some embodiments, a first optical path in a direction perpendicular to the first substrate is defined at a position of the display apparatus 140 corresponding to a location of the pixel hole 2502, and a second optical path in the direction perpendicular to the first substrate is defined at a position of the display apparatus 140 corresponding to a location outside the pixel hole 2502, wherein the first optical path is equal to the second optical path.

The first optical path can be understood as an optical path of the optical signals passing through the display apparatus 140 from the position corresponding to the location of the pixel hole 2502 in the direction perpendicular to the first substrate 220. The first optical path can specifically be a sum of products of the thickness and the refractive index corresponding to each layer of the second substrate 280, the light-extracting material layer 270, the filling layer 290, the common electrode layer 260, the organic light-emitting layer 252, the anode metal layer 240, and the first substrate 220.

The second optical path can be understood as an optical path of the optical signals passing through the display apparatus 140 from the position not corresponding to the location of the pixel hole 2502 in the direction perpendicular to the first substrate 220. The second optical path can specifically be a sum of products of the thickness and the refractive index of each layer of the second substrate 280, the light-extracting material layer 270, the common electrode layer 260, the pixel definition layer 250, the anode metal layer 240, and the first substrate 220.

Because each layer of the second substrate 280, the light-extracting material layer 270, the common electrode layer 260, the anode metal layer 240, and the first substrate 220 covers another layer as a whole, and the thicknesses of different parts of each layer are approximately the same, the optical path difference between the first optical path and the second optical path corresponding to the second substrate 280, the light-extracting material layer 270, the common electrode layer 260, the anode metal layer 240, and the first substrate 220 can be ignored.

It should be noted that the first optical path equal to the second optical path can be understood to mean that the first optical path and the second optical path are approximately equal.

In some embodiments, an anode metal layer 240 and a common electrode layer 260 jointly drive an organic light-emitting layer 252 to display an image. The display apparatus 140 further includes a thin film transistor 248. The first anode metal layer 242, the second anode metal layer 246, and the organic light-emitting layer 252 are respectively connected to different electrodes of the thin film transistor 248. Also, the first anode metal layer 242 and the second anode metal layer 246 are controlled by the thin film transistor 248 to provide a positive signal to the organic light-emitting layer 252. After the positive signal is provided to the organic light-emitting layer 252, a negative electrode provided by the common electrode layer 260 is combined to control whether the organic light-emitting layer 252 emits light.

In some embodiments, a material of the first anode metal layer 242 is nano-silver.

The first anode metal layer 242 may be disposed between the organic light emitter 2522 and the planarization layer 244. The first anode metal layer 242 may include a plurality of first conductive wires and is made of nano-silver. Each of the first conductive wires made of nano-silver can be made thinner under the condition that impedance characteristic is satisfied. The thinner first metal layer has a smaller thickness and has a smaller influence on the first optical path. Because the plurality of first conductive wires of the first anode metal layer 242 do not cover another whole layer, the thickness of the first anode metal layer 242 is smaller, and the influence on the first optical path is also smaller. It should be noted that a material of the second anode metal layer 246 may be indium tin oxide (ITO) or nano-silver. It should be noted that the plurality of first conductive wires also extend to positions between the planarization layer 244 and the pixel definition layer 250, thereby reducing the influence on the second optical path.

In some embodiments, a material of the second anode metal layer 246 is nano-silver.

The first anode metal layer 242 may be disposed between the pixel definition layer 250 and the planarization layer 244. The second anode metal layer 246 may include a plurality of second conductive wires and is made of nano-silver. Each of the second conductive wires made of nano-silver can be made thinner under the condition that impedance characteristic is satisfied. The thinner second metal layer has a smaller thickness and has a smaller influence on the second optical path. Because the plurality of second conductive wires of the second anode metal layer 246 do not cover another whole layer, the thickness of the second anode metal layer 246 is smaller, and the influence on the second optical path is also smaller. It should be noted that the material of the first anode metal layer 242 can be indium tin oxide (ITO) or nano-silver.

In some embodiments, materials of the first anode metal layer 242 and the second anode metal layer 246 are nano-silver.

Both of the first anode metal layer 242 and the second anode metal layer 246 are made of nano-silver, and the thicknesses of the first anode metal layer 242 and the second anode metal layer 246 are smaller, and the influence on the first optical path and the second optical path is also smaller.

In some embodiments, a first compensation layer may be provided corresponding to the first anode metal layer 242, that is, the first compensation layer is filled between a plurality of first conductive wires. The first compensation layer is made of insulation material with light transmission and has optical parameters similar to that of the first conductive wires, thereby the first optical path and the second optical path being not affected. The thicknesses of the first compensation layer and the plurality of first conductive wires are the same.

A second compensation layer can be provided corresponding to the second anode metal layer 246, that is, the second compensation layer is filled between a plurality of second conductive wires. The second compensation layer is made of insulation material with light transmission and has optical parameters similar to that of the second conductive wires, thereby the first optical path and the second optical path being not affected.

The thicknesses of the second compensation layer and the plurality of second conductive wires are the same.

Please continue to refer to FIG. 6, in some embodiments, the display apparatus 140 further includes a light-shielding block 272 used to block light and a thin film transistor 248.

The thin film transistor 248 is disposed between the first substrate 220 and the organic light-emitting layer 252, the light-shielding block 272 is disposed between the common electrode layer 260 and the second substrate 280, and the light-shielding block 272 is at least partially disposed opposite to the thin film transistor 248.

The light-shielding block 272 may be a black or dark-colored material, and the light-shielding block 272 may be used to block light entering the display apparatus 140. The light-shielding block 272 is disposed corresponding to the thin film transistor 248. The light-shielding block 272 may be disposed between the organic light-emitting layer 252 and the second substrate 280. Each light shielding block 272 is at least partially disposed opposite to one thin film transistor 248. For example, a projection of the thin film transistor 248 on the first substrate 220 may be located within a projection of the light-shielding block 272 on the first substrate 220. In this way, it is possible to prevent light from being reflected and refracted by the thin film transistor 248 after entering the display apparatus 140, resulting in stray light interfering with imaging.

In some embodiments, the light-shielding block 272 may be disposed in the light-extracting material layer 270. For example, the light-extraction material layer 270 defines a through-hole or groove at a position corresponding to the thin film transistor 248, and the light-shielding block 272 is correspondingly disposed in the through-hole or groove, wherein an opening of the groove may face the second substrate 280 or the common electrode layer 260.

In one implementation, a position of the second substrate 280 corresponding to the thin film transistor 248 may define the groove, and the light-shielding block 272 is correspondingly disposed in the groove of the second substrate 280, wherein the opening of the groove of the second substrate 280 faces the common electrode layer 260. In one implementation, the light-shielding block 272 may also be disposed in a gap between the organic light-emitting layer 252 and the common electrode layer 260.

Please continue to refer to FIG. 7, in some embodiments, the display apparatus 140 includes a light-transmitting region 132 and a main-body region 134, an area of the light-transmitting region 132 is smaller than an area of the main-body region 134, and light transmittance of the light-transmitting region 132 is greater than light transmittance of the main-body region 134.

The light-transmitting region 132 is connected to a first driving module 1444, the main-body region 134 is connected to a second driving module 1442, the first driving module 1444 drives the light-transmitting region 132 of the display apparatus 140, and the second driving module 1442 drives the main-body region 134 of the display apparatus 140. The first driving module 1442 and the second driving module 1444 can cooperatively drive, such that the light-transmitting region 132 and the main-body region 134 display the same image together. For example, the light-transmitting region 132 displays a part of the image, and the main-body region 134 displays the remaining part of the image. When the camera module 160 needs to acquire an image, the first driving module 1444 drives the light-transmitting region 132 to turn off a display function, and the second driving module 1442 can continue to drive the main-body region 134 to display images, and the camera module 160 acquires external optical signals through the light-transmitting region 132 which is turned off the display function, and the image is obtained according to the optical signals.

In some embodiments, a distribution density of pixel holes within the light-transmitting region 132 is less than a distribution density of pixel holes within the main-body region 134.

Please refer to FIG. 8, specifically, in some embodiments, the pixel definition layer 250 includes a first part 254 and a second part 256. The first part 254 corresponds to the light-transmitting region. The second part 256 corresponds to the main-body region. An area of the first part 254 is smaller than an area of the second part 256. Light transmittance of the first part 254 is greater than light transmittance of the second electrode part 2604. The camera module is used to acquire images through the first part 254 of the display device 140.

Correspondingly, the camera module can acquire optical signals through a region corresponding to the first part 254 of the display apparatus 140, and light transmittance of the display apparatus corresponding to the first part 254 is greater than light transmittance of the display apparatus corresponding to the second part 256. Specifically, a distribution density of organic light emitters corresponding to the first part 254 is smaller, that is, smaller than a distribution density of organic light emitters corresponding to the second part 256. The distribution density of organic light emitters corresponding to the first part 254 is smaller, and the distribution density of thin film transistors that are opaque and corresponding to the organic light emitters in a manner of one-by-one correspondence is also smaller, thereby improving the light transmittance of the display apparatus corresponding to the first part 254.

In some embodiments, a distribution density of organic light emitters within the first part 254 is less than a distribution density of organic light emitters within the second part 256. It can also be understood that a distance between two adjacent pixel holes within the first part 254 is greater than a distance between two adjacent pixel holes within the second part 256. Light transmittance of the pixel definition layer 250 is greater than light transmittance of each of the organic light emitters. A proportion of the organic light-emitting layer of the first part 254 is smaller, such that the light transmittance of the first part 254 is greater than the light transmittance of the second part 256. In addition, each of the organic light emitters is provided with one of the thin film transistors that are opaque. The distribution density of organic light emitters within the first part 254 is smaller, and the distribution density of corresponding thin film transistors is also smaller, such that the light transmittance of the first part 254 is greater than the light transmittance of the second part 256.

In some embodiments, the first part 254 is located at an end of the pixel definition layer 250. Specifically, the first part 254 may be located at a top end or bottom end or on one side, of the pixel definition layer 250. For example, the pixel definition layer 250 is shaped like a rectangle, the second part 256 is shaped like a rectangle with a notch, and the first part 254 is disposed within the notch. The notch may be defined on a top edge or a bottom edge, or one side edge of the second part 256. Certainly, the first part 254 can also be disposed in a middle portion of the pixel definition layer 250. Also, it can be understood that the second part 256 has a through-hole penetrating the second part 256 in a direction of thickness. The first part 254 is disposed in the through-hole.

The light-transmitting region and the main-body region are mainly different in the pixel definition layer 250 and the organic display layer. The light-transmitting region and the main-body region may share the same one first substrate 220, second substrate 280, and so on. The filling layer 290 may only be provided within the light-transmitting region or may be provided within the light-transmitting region and the main-body region.

It should be noted that, in conjunction with FIG. 5, the anode metal layer 240 corresponding to the first part 254 can be made of a material with high light transmissions, such as ITO, nano-silver, and the like. The anode metal layer 240 corresponding to the second part 256 may be made of a material with high light transmissions or may be made of a material with low light transmission or opacity.

Please continue to refer to FIG. 9, in some embodiments, the display apparatus 140 may include a first display panel 1422 and a second display panel 1424. The first display panel 1422 defines a notch 110 penetrating the first display panel 1422 in a direction of thickness of the first display panel 1422. The first display panel 1422 is the display panel 142 that is normally displayed. The second display panel 1424 is disposed in the notch 110. The second display panel 1424 corresponds to the light-transmitting region of the display apparatus 140. The first display panel 1422 corresponds to the main-body region of the display apparatus 140. The camera module can be used to acquire images through the second display panel 1424.

The first display panel 1422 and the second display panel 1424 are two independent display panels. The first display panel 1422 and the second display panel 1424 are manufactured, respectively. The second display panel 1424 is then placed in the notch 100 of the first display panel 1422.

It should be noted that the first display panel 1422 is connected to the second drive module 1442, the second display panel 1424 is connected to the first drive module 1444, the first drive module 1444 drives the second display panel 1424, the second drive module 1442 drives the first display panel 1442, and the first driving module 1442 and the second driving module 1444 cooperatively drive, such that the first display panel 1422 and the second display panel 1424 display the same image together. For example, the first display panel 1422 displays a part of the image, the second display panel 1424 displays the remaining part of the image. When an image needs to be acquired through the second display panel 1424, the first drive module 1444 drives the second display panel 1424 to turn off a display function, the second drive module 1442 can continue to drive the first display panel 1422 to display images, and external optical signals are acquired through the second display panel 1424 that is turned off the display function, to obtain the image according to the optical signals.

## Claims

1. An electronic device (100) comprising a display apparatus (140) and a camera module (160), wherein the display apparatus (140) comprises:
a pixel definition layer (250) defined with a plurality of pixel holes (2502) in an array manner;
a plurality of organic light emitters (2522), each of the plurality of organic light emitters (2522) disposed in one of the plurality of pixel holes (2502);
a common electrode layer (260) covering the organic light emitters (2522) and the pixel definition layer (250); and
a filling layer (290) comprising a plurality of filling members (2902), each of the plurality of filling members (2902) disposed on one side of the common electrode layer (260) away from the plurality of organic light emitters (2522) and opposite to one of the plurality of pixel holes (2502);
wherein a difference between refractive indices of the pixel definition layer (250) and each of the plurality of filling members (2902) is smaller than a difference between refractive indices of the pixel definition layer (250) and vacuum; and **characterized in that**
the camera module (160) is at least partially disposed face to at least one of the plurality of pixel holes (2502) and configured to acquire an image through the display apparatus (140).

2. The electronic device (100) according to claim 1, wherein the common electrode layer (260) is defined with a plurality of first grooves (2608) on a side opposite to the pixel definition layer (250), each of the plurality of filling members (2902) is disposed in one of the plurality of first grooves (2608).

3. The electronic device (100) according to claim 1, wherein the display apparatus (140) further comprises a light-extracting material layer (270) covering the common electrode layer (260), the light-extracting material layer (270) is defined with a plurality of second grooves (2702) opposite to the plurality of pixel holes (2502), an opening of each of the plurality of second grooves (2702) is away from one of the plurality of pixel holes (2502), and each of the plurality of filling members (2902) is disposed in one of the plurality of second grooves (2702).

4. The electronic device (100) of claim 1, wherein the display apparatus (140) further comprises a first substrate (220), an anode metal layer (240), and a second substrate (280), which are stacked;
the pixel definition layer (250) is disposed between the anode metal layer (240) and the common electrode layer (260), and the common electrode layer (260) is disposed between the pixel definition layer (250) and the second substrate (280); and
the anode metal layer (240) comprises a first anode metal layer (242), a planarization layer (244), and a second anode metal layer (246), which are stacked, wherein the first anode metal layer (242) is disposed between the first substrate (220) and the planarization layer (244), and the second anode metal layer (246) is disposed between the planarization layer (244) and the pixel definition layer (250).

5. The electronic device (100) according to claim 1, wherein the display apparatus (140) comprises a light-transmitting region (132) and a main-body region (134), an area of the light-transmitting region (132) is smaller than an area of the main-body region (134), light transmittance of the light-transmitting region (132) is greater than light transmittance of the main-body region (134), and the camera module (160) is at least partially disposed opposite to the light-transmitting region (132).

6. A display apparatus (140), comprising:
a pixel definition layer (250) defined with a pixel hole (2502);
an organic light emitter (2522) disposed in the pixel hole (2502);
a common electrode layer (260) covering the organic light emitter (2522) and the pixel definition layer (250); and
a filling layer (290) comprising a filling member (2902) disposed on one side of the common electrode layer (260) away from the organic light emitter (2522) and opposite to the pixel hole (2502);
wherein a difference between refractive indices of the pixel definition layer (250) and the filling member (2902) is smaller than a difference between refractive indices of the pixel definition layer (250) and vacuum, **characterized in that** a refractive index of the filling layer (290) is smaller than the refractive index of the pixel definition layer (250).

7. The display apparatus (140) according to claim 6, wherein the common electrode layer (260) comprises a first electrode part (2602), a second electrode part (2604), and a third electrode part (2606), the first electrode part (2602) is disposed in the pixel hole (2502) and covers the organic light emitter (2522), the second electrode part (2604) covers the pixel definition layer (250), the third electrode part (2606) is connected to the first electrode part (2602) and the second electrode part (2604), the first electrode part (2602) and the third electrode part (2606) form a first groove (2608) together, and the filling member (2902) is disposed in the first groove (2608).

8. The display apparatus (140) according to claim 7, wherein the second electrode part (2604) comprises a first surface (2605) away from the pixel definition layer (250), and a surface of the filling member (2902) away from the organic light emitter (2522) is aligned with the first surface (2605).

9. The display apparatus (140) according to claim 6, wherein the filling layer (290) further comprises a connection member (2904) that covers the common electrode layer (260) and is connected to the filling member (2902).

10. The display apparatus (140) according to claim 7, wherein the second electrode part (2604) comprises a first surface (2605) away from the pixel definition layer (250), and a surface of the filling member (2902) away from the organic light emitter (2522) is lower or higher than the first surface (2605).

11. The display apparatus (140) according to claim 6, wherein the display apparatus (140) further comprises a light-extracting material layer (270) covering the common electrode layer (260), the light-extracting material layer (270) is formed with a second groove (2702) opposite to the pixel hole (2502), an opening of the second groove (2702) is away from the pixel hole (2502), and the filling member (2902) is disposed in the second groove (2702).

12. The display apparatus (140) according to claim 11, wherein the light-extracting material layer (270) comprises a third surface (2704) away from the common electrode layer (260), and a surface of the filling member (2902) away from the organic light emitter (2522) is aligned with the third surface (2704).

13. The display apparatus (140) according to claim 6, wherein the display apparatus (140) further comprises a first substrate (220), an anode metal layer (240), and a second substrate (280), which are stacked;
the pixel definition layer (250) is disposed between the anode metal layer (240) and the common electrode layer (260), and the common electrode layer (260) is disposed between the pixel definition layer (250) and the second substrate (280); and
the anode metal layer (240) comprises a first anode metal layer (242), a planarization layer (244), and a second anode metal layer (246), which are stacked, wherein the first anode metal layer (242) is disposed between the first substrate (220) and the planarization layer (244), and the second anode metal layer (246) is disposed between the planarization layer (244) and the pixel definition layer (250).

14. The display apparatus (140) according to claim 13, wherein a first optical path in a direction perpendicular to the first substrate (220) is defined at a position of the display apparatus (140) corresponding to a location of the pixel hole (2502), a second optical path in the direction perpendicular to the first substrate (220) is defined at a position of the display apparatus (140) corresponding to a location outside the pixel hole (2502), and the first optical path is equal to the second optical path.

15. The display apparatus (140) according to claim 13, wherein the display apparatus (140) further comprises a light-shielding block (272) configured to block light and a thin film transistor (248); and
the thin film transistor (248) is disposed between the first substrate (220) and the organic light-emitting layer (252), the light-shielding block (272) is disposed between the common electrode layer (260) and the second substrate (280), and the light-shielding block (272) is at least partially disposed opposite to the thin film transistor (248).

## Patentansprüche

1. Elektronische Vorrichtung (100), die eine Anzeigevorrichtung (140) und ein Kameramodul (160) umfasst, wobei die Anzeigevorrichtung (140) Folgendes umfasst:
eine Pixeldefinitionsschicht (250), die mit einer Mehrzahl von Pixellöchern (2502) in einer feldartigen Anordnung definiert ist;
eine Mehrzahl organischer Lichtemitter (2522), wobei jeder aus der Mehrzahl organischer Lichtemitter (2522) in einem aus der Mehrzahl von Pixellöchern (2502) angeordnet ist;
eine gemeinsame Elektrodenschicht (260), welche die organischen Lichtemitter (2522) und die Pixeldefinitionsschicht (250) bedeckt; und
eine Füllschicht (290), die eine Mehrzahl von Füllelementen (2902) umfasst, wobei jedes aus der Mehrzahl von Füllelementen (2902) auf einer Seite der gemeinsamen Elektrodenschicht (260), entfernt von der Mehrzahl organischer Lichtemitter (2522) und gegenüber einem aus der Mehrzahl von Pixellöchern (2502), angeordnet ist;
wobei ein Unterschied zwischen den Brechungsindizes der Pixeldefinitionsschicht (250) und jedes aus der Mehrzahl von Füllelementen (2902) kleiner als ein Unterschied zwischen den Brechungsindizes der Pixeldefinitionsschicht (250) und von Vakuum ist; und **dadurch gekennzeichnet, dass**
das Kameramodul (160) wenigstens teilweise wenigstens einem aus der Mehrzahl von Pixellöchern (2502) zugewandt angeordnet und dazu ausgestaltet ist, durch die Anzeigevorrichtung (140) hindurch ein Bild aufzunehmen.

2. Elektronische Vorrichtung (100) nach Anspruch 1, wobei die gemeinsame Elektrodenschicht (260) mit einer Mehrzahl erster Nuten (2608) auf einer Seite gegenüber der Pixeldefinitionsschicht (250) definiert ist, wobei jedes aus der Mehrzahl von Füllelementen (2902) in einer aus der Mehrzahl erster Nuten (2608) angeordnet ist.

3. Elektronische Vorrichtung (100) nach Anspruch 1, wobei die Anzeigevorrichtung (140) ferner eine Lichtauskopplungsmaterialschicht (270) umfasst, welche die gemeinsame Elektrodenschicht (260) bedeckt, die Lichtauskopplungsmaterialschicht (270) mit einer Mehrzahl zweiter Nuten (2702) gegenüber der Mehrzahl von Pixellöchern (2502) definiert ist, eine Öffnung jeder aus der Mehrzahl zweiter Nuten (2702) von einem aus der Mehrzahl von Pixellöchern (2502) entfernt ist und jedes aus der Mehrzahl von Füllelementen (2902) in einer aus der Mehrzahl zweiter Nuten (2702) angeordnet ist.

4. Elektronische Vorrichtung (100) nach Anspruch 1, wobei die Anzeigevorrichtung (140) ferner ein erstes Substrat (220), eine Anodenmetallschicht (240) und ein zweites Substrat (280) umfasst, die gestapelt sind;
die Pixeldefinitionsschicht (250) zwischen der Anodenmetallschicht (240) und der gemeinsamen Elektrodenschicht (260) angeordnet ist und die gemeinsame Elektrodenschicht (260) zwischen der Pixeldefinitionsschicht (250) und dem zweiten Substrat (280) angeordnet ist; und
die Anodenmetallschicht (240) eine erste Anodenmetallschicht (242), eine Planarisierungsschicht (244) und eine zweite Anodenmetallschicht (246) umfasst, die gestapelt sind, wobei die erste Anodenmetallschicht (242) zwischen dem ersten Substrat (220) und der Planarisierungsschicht (244) angeordnet ist und die zweite Anodenmetallschicht (246) zwischen der Planarisierungsschicht (244) und der Pixeldefinitionsschicht (250) angeordnet ist.

5. Elektronische Vorrichtung (100) nach Anspruch 1, wobei die Anzeigevorrichtung (140) einen Lichtdurchlassbereich (132) und einen Hauptkörperbereich (134) umfasst, ein Flächeninhalt des Lichtdurchlassbereichs (132) kleiner als ein Flächeninhalt des Hauptkörperbereichs (134) ist, die Lichtdurchlässigkeit des Lichtdurchlassbereichs (132) größer als die Lichtdurchlässigkeit des Hauptkörperbereichs (134) ist und das Kameramodul (160) wenigstens teilweise gegenüber dem Lichtdurchlassbereich (132) angeordnet ist.

6. Anzeigevorrichtung (140), umfassend:
eine Pixeldefinitionsschicht (250), die mit einem Pixelloch (2502) definiert ist;
einen organischen Lichtemitter (2522), der in dem Pixelloch (2502) angeordnet ist;
eine gemeinsame Elektrodenschicht (260), welche den organischen Lichtemitter (2522) und die Pixeldefinitionsschicht (250) bedeckt; und
eine Füllschicht (290), die ein Füllelement (2902) umfasst, das auf einer Seite der gemeinsamen Elektrodenschicht (260), entfernt von dem organischen Lichtemitter (2522) und gegenüber dem Pixelloch (2502), angeordnet ist;
wobei ein Unterschied zwischen den Brechungsindizes der Pixeldefinitionsschicht (250) und des Füllelements (2902) kleiner als ein Unterschied zwischen den Brechungsindizes der Pixeldefinitionsschicht (250) und von Vakuum ist, **dadurch gekennzeichnet, dass** ein Brechungsindex der Füllschicht (290) kleiner als der Brechungsindex der Pixeldefinitionsschicht (250) ist.

7. Anzeigevorrichtung (140) nach Anspruch 6, wobei die gemeinsame Elektrodenschicht (260) einen ersten Elektrodenteil (2602), einen zweiten Elektrodenteil (2604) und einen dritten Elektrodenteil (2606) umfasst, der erste Elektrodenteil (2602) in dem Pixelloch (2502) angeordnet ist und den organischen Lichtemitter (2522) bedeckt, der zweite Elektrodenteil (2604) die Pixeldefinitionsschicht (250) bedeckt, der dritte Elektrodenteil (2606) mit dem ersten Elektrodenteil (2602) und dem zweiten Elektrodenteil (2604) verbunden ist, der erste Elektrodenteil (2602) und der dritte Elektrodenteil (2606) zusammen eine erste Nut (2608) ausbilden und das Füllelement (2902) in der ersten Nut (2608) angeordnet ist.

8. Anzeigevorrichtung (140) nach Anspruch 7, wobei der zweite Elektrodenteil (2604) eine erste Oberfläche (2605) umfasst, die von der Pixeldefinitionsschicht (250) entfernt ist, und eine Oberfläche des Füllelements (2902), die von dem organischen Lichtemitter (2522) entfernt ist, mit der ersten Oberfläche (2605) ausgerichtet ist.

9. Anzeigevorrichtung (140) nach Anspruch 6, wobei die Füllschicht (290) ferner ein Verbindungselement (2904) umfasst, das die gemeinsame Elektrodenschicht (260) bedeckt und mit dem Füllelement (2902) verbunden ist.

10. Anzeigevorrichtung (140) nach Anspruch 7, wobei der zweite Elektrodenteil (2604) eine erste Oberfläche (2605) umfasst, die von der Pixeldefinitionsschicht (250) entfernt ist, und eine Oberfläche des Füllelements (2902), die von dem organischen Lichtemitter (2522) entfernt ist, niedriger oder höher als die erste Oberfläche (2605) ist.

11. Anzeigevorrichtung (140) nach Anspruch 6, wobei die Anzeigevorrichtung (140) ferner eine Lichtauskopplungsmaterialschicht (270) umfasst, welche die gemeinsame Elektrodenschicht (260) bedeckt, die Lichtauskopplungsmaterialschicht (270) mit einer zweiten Nut (2702) gegenüber dem Pixelloch (2502) ausgebildet ist, eine Öffnung der zweiten Nut (2702) von dem Pixelloch (2502) entfernt ist und das Füllelement (2902) in der zweiten Nut (2702) angeordnet ist.

12. Anzeigevorrichtung (140) nach Anspruch 11, wobei die Lichtauskopplungsmaterialschicht (270) eine dritte Oberfläche (2704) umfasst, die von der gemeinsamen Elektrodenschicht (260) entfernt ist, und eine Oberfläche des Füllelements (2902), die von dem organischen Lichtemitter (2522) entfernt ist, mit der dritten Oberfläche (2704) ausgerichtet ist.

13. Anzeigevorrichtung (140) nach Anspruch 6, wobei die Anzeigevorrichtung (140) ferner ein erstes Substrat (220), eine Anodenmetallschicht (240) und ein zweites Substrat (280) umfasst, die gestapelt sind;
die Pixeldefinitionsschicht (250) zwischen der Anodenmetallschicht (240) und der gemeinsamen Elektrodenschicht (260) angeordnet ist und die gemeinsame Elektrodenschicht (260) zwischen der Pixeldefinitionsschicht (250) und dem zweiten Substrat (280) angeordnet ist; und
die Anodenmetallschicht (240) eine erste Anodenmetallschicht (242), eine Planarisierungsschicht (244) und eine zweite Anodenmetallschicht (246) umfasst, die gestapelt sind, wobei die erste Anodenmetallschicht (242) zwischen dem ersten Substrat (220) und der Planarisierungsschicht (244) angeordnet ist und die zweite Anodenmetallschicht (246) zwischen der Planarisierungsschicht (244) und der Pixeldefinitionsschicht (250) angeordnet ist.

14. Anzeigevorrichtung (140) nach Anspruch 13, wobei ein erster Lichtweg in einer Richtung senkrecht zu dem ersten Substrat (220) an einer Stelle der Anzeigevorrichtung (140) definiert ist, die einer Position des Pixellochs (2502) entspricht, ein zweiter Lichtweg in der Richtung senkrecht zu dem ersten Substrat (220) an einer Stelle der Anzeigevorrichtung (140) definiert ist, die einer Position außerhalb des Pixellochs (2502) entspricht, und der erste Lichtweg gleich dem zweiten Lichtweg ist.

15. Anzeigevorrichtung (140) nach Anspruch 13, wobei die Anzeigevorrichtung (140) ferner einen Lichtabschirmblock (272), der zum Blockieren von Licht ausgestaltet ist, und einen Dünnschichttransistor (248) umfasst; und
der Dünnschichttransistor (248) zwischen dem ersten Substrat (220) und der organischen Lichtemissionsschicht (252) angeordnet ist, der Lichtabschirmblock (272) zwischen der gemeinsamen Elektrodenschicht (260) und dem zweiten Substrat (280) angeordnet ist und der Lichtabschirmblock (272) wenigstens teilweise gegenüber dem Dünnschichttransistor (248) angeordnet ist.

## Revendications

1. Dispositif électronique (100) comprenant un appareil d'affichage (140) et un module de caméra (160), dans lequel l'appareil d'affichage (140) comprend :
une couche de définition de pixels (250) définie de façon à présenter une pluralité de trous de pixels (2502) à la manière d'un réseau ;
une pluralité d'émetteurs de lumière organiques (2522), chacun de la pluralité d'émetteurs de lumière organiques (2522) étant disposé dans l'un de la pluralité de trous de pixels (2502) ;
une couche d'électrode commune (260) recouvrant les émetteurs de lumière organiques (2522) et la couche de définition de pixels (250) ; et
une couche de remplissage (290) comprenant une pluralité d'éléments de remplissage (2902), chacun de la pluralité d'éléments de remplissage (2902) étant disposé sur un côté de la couche d'électrode commune (260) de manière éloignée de la pluralité d'émetteurs de lumière organiques (2522) et à l'opposé de l'un de la pluralité de trous de pixels (2502) ;
dans lequel une différence entre les indices de réfraction de la couche de définition de pixels (250) et de chacun de la pluralité d'éléments de remplissage (2902) est inférieure à une différence entre les indices de réfraction de la couche de définition de pixels (250) et du vide ; et **caractérisé en ce que**
le module de caméra (160) est au moins partiellement disposé face à au moins l'un de la pluralité de trous de pixels (2502) et est configuré pour acquérir une image par le biais de l'appareil d'affichage (140).

2. Dispositif électronique (100) selon la revendication 1, dans lequel la couche d'électrode commune (260) est définie de façon à présenter une pluralité de premières rainures (2608) sur un côté opposé à la couche de définition de pixels (250), chacun de la pluralité d'éléments de remplissage (2902) étant disposé dans l'une de la pluralité de premières rainures (2608).

3. Dispositif électronique (100) selon la revendication 1, dans lequel l'appareil d'affichage (140) comprend en outre une couche de matériau d'extraction de lumière (270) recouvrant la couche d'électrode commune (260), la couche de matériau d'extraction de lumière (270) est définie de façon à présenter une pluralité de deuxièmes rainures (2702) opposées à la pluralité de trous de pixels (2502), une ouverture de chacune de la pluralité de deuxièmes rainures (2702) est éloignée de l'un de la pluralité de trous de pixels (2502), et chacun de la pluralité d'éléments de remplissage (2902) est disposé dans l'une de la pluralité de deuxièmes rainures (2702).

4. Dispositif électronique (100) selon la revendication 1, dans lequel l'appareil d'affichage (140) comprend en outre un premier substrat (220), une couche métallique d'anode (240), et un deuxième substrat (280), qui sont empilés ;
la couche de définition de pixels (250) est disposée entre la couche métallique d'anode (240) et la couche d'électrode commune (260), et la couche d'électrode commune (260) est disposée entre la couche de définition de pixels (250) et le deuxième substrat (280) ; et
la couche métallique d'anode (240) comprend une première couche métallique d'anode (242), une couche de planarisation (244), et une deuxième couche métallique d'anode (246), qui sont empilées, dans lequel la première couche métallique d'anode (242) est disposée entre le premier substrat (220) et la couche de planarisation (244), et la deuxième couche métallique d'anode (246) est disposée entre la couche de planarisation (244) et la couche de définition de pixels (250).

5. Dispositif électronique (100) selon la revendication 1, dans lequel l'appareil d'affichage (140) comprend une région de transmission de la lumière (132) et une région de corps principal (134), une zone de la région de transmission de la lumière (132) est plus petite qu'une zone de la région de corps principal (134), la transmittance de lumière de la région de transmission de la lumière (132) est supérieure à la transmittance de lumière de la région de corps principal (134), et le module de caméra (160) est au moins partiellement disposé à l'opposé de la région de transmission de la lumière (132) .

6. Appareil d'affichage (140), comprenant :
une couche de définition de pixels (250) définie de façon à présenter un trou de pixel (2502) ;
un émetteur de lumière organique (2522) disposé dans le trou de pixel (2502) ;
une couche d'électrode commune (260) recouvrant l'émetteur de lumière organique (2522) et la couche de définition de pixels (250) ; et
une couche de remplissage (290) comprenant un élément de remplissage (2902) disposé sur un côté de la couche d'électrode commune (260) de manière éloignée de l'émetteur de lumière organique (2522) et à l'opposé du trou de pixel (2502) ;
dans lequel une différence entre les indices de réfraction de la couche définition de pixels (250) et de l'élément de remplissage (2902) est inférieure à une différence entre les indices de réfraction de la couche définition de pixels (250) et du vide, **caractérisé en ce qu'**un indice de réfraction de la couche de remplissage (290) est inférieur à l'indice de réfraction de la couche définition de pixels (250).

7. Appareil d'affichage (140) selon la revendication 6, dans lequel la couche d'électrode commune (260) comprend une première partie d'électrode (2602), une deuxième partie d'électrode (2604), et une troisième partie d'électrode (2606), la première partie d'électrode (2602) est disposée dans le trou de pixel (2502) et recouvre l'émetteur de lumière organique (2522), la deuxième partie d'électrode (2604) recouvre la couche de définition de pixels (250), la troisième partie d'électrode (2606) est connectée à la première partie d'électrode (2602) et à la deuxième partie d'électrode (2604), la première partie d'électrode (2602) et la troisième partie d'électrode (2606) forment ensemble une première rainure (2608), et l'élément de remplissage (2902) est disposé dans la première rainure (2608).

8. Appareil d'affichage (140) selon la revendication 7, dans lequel la deuxième partie d'électrode (2604) comprend une première surface (2605) éloignée de la couche de définition de pixels (250), et une surface de l'élément de remplissage (2902) éloignée de l'émetteur de lumière organique (2522) est alignée avec la première surface (2605).

9. Appareil d'affichage (140) selon la revendication 6, dans lequel la couche de remplissage (290) comprend en outre un élément de connexion (2904) qui recouvre la couche d'électrode commune (260) et est connecté à l'élément de remplissage (2902).

10. Appareil d'affichage (140) selon la revendication 7, dans lequel la deuxième partie d'électrode (2604) comprend une première surface (2605) éloignée de la couche de définition de pixels (250), et une surface de l'élément de remplissage (2902) éloignée de l'émetteur de lumière organique (2522) est inférieure ou supérieure à la première surface (2605).

11. Appareil d'affichage (140) selon la revendication 6, dans lequel l'appareil d'affichage (140) comprend en outre une couche de matériau d'extraction de lumière (270) recouvrant la couche d'électrode commune (260), la couche de matériau d'extraction de lumière (270) est formée de façon à présenter une deuxième rainure (2702) à l'opposé du trou de pixel (2502), une ouverture de la deuxième rainure (2702) est éloignée du trou de pixel (2502), et l'élément de remplissage (2902) est disposé dans la deuxième rainure (2702).

12. Appareil d'affichage (140) selon la revendication 11, dans lequel la couche de matériau d'extraction de lumière (270) comprend une troisième surface (2704) éloignée de la couche d'électrode commune (260), et une surface de l'élément de remplissage (2902) éloignée de l'émetteur de lumière organique (2522) est alignée avec la troisième surface (2704).

13. Appareil d'affichage (140) selon la revendication 6, dans lequel l'appareil d'affichage (140) comprend en outre un premier substrat (220), une couche métallique d'anode (240), et un deuxième substrat (280), qui sont empilés ;
la couche de définition de pixels (250) est disposée entre la couche métallique d'anode (240) et la couche d'électrode commune (260), et la couche d'électrode commune (260) est disposée entre la couche de définition de pixels (250) et le deuxième substrat (280) ; et
la couche métallique d'anode (240) comprend une première couche métallique d'anode (242), une couche de planarisation (244), et une deuxième couche métallique d'anode (246), qui sont empilées, dans lequel la première couche métallique d'anode (242) est disposée entre le premier substrat (220) et la couche de planarisation (244), et la deuxième couche métallique d'anode (246) est disposée entre la couche de planarisation (244) et la couche de définition de pixels (250).

14. Appareil d'affichage (140) selon la revendication 13, dans lequel un premier trajet optique dans une direction perpendiculaire au premier substrat (220) est défini à une position de l'appareil d'affichage (140) qui correspond à un emplacement du trou de pixel (2502), un deuxième trajet optique dans la direction perpendiculaire au premier substrat (220) est défini à une position de l'appareil d'affichage (140) qui correspond à un emplacement situé à l'extérieur du trou de pixel (2502), et le premier trajet optique est égal au deuxième trajet optique.

15. Appareil d'affichage (140) selon la revendication 13, dans lequel l'appareil d'affichage (140) comprend en outre un bloc de protection contre la lumière (272) configuré pour occulter la lumière et un transistor à couches minces (248) ; et
le transistor à couches minces (248) est disposé entre le premier substrat (220) et la couche émettrice de lumière organique (252), le bloc de protection contre la lumière (272) est disposé entre la couche d'électrode commune (260) et le deuxième substrat (280), et le bloc de protection contre la lumière (272) est au moins partiellement disposé à l'opposé du transistor à couches minces (248).
